# EUROPEAN PATENT SPECIFICATION

(11) **EP 3 082 232 B1**
(45) Date of publication and mention of the grant of the patent: **10.04.2019**
(21) Application number: 14869940.8
(22) Date of filing: 12.12.2014
(51) Int. Cl.: H02K 11/00, B62D 5/04, H05K 7/20, H05K 7/14

(54) **ELECTRONIC CONTROL UNIT, ELECTRIC POWER STEERING DEVICE, AND VEHICLE**
ELEKTRONISCHE STEUEREINHEIT, ELEKTRISCHE SERVOLENKUNG UND FAHRZEUG
UNITÉ DE COMMANDE ÉLECTRONIQUE, DISPOSITIF DE DIRECTION À ASSISTANCE ÉLECTRIQUE ET VÉHICULE

(30) Priority: 13.12.2013 JP 2013258298; 13.12.2013 JP 2013258299; 13.12.2013 JP 2013258300; 13.12.2013 JP 2013258301; 20.12.2013 JP 2013263957; 20.12.2013 JP 2013263958; 20.12.2013 JP 2013263959; 20.12.2013 JP 2013263960
(43) Date of publication of application: 19.10.2016
(73) Proprietor: NSK Ltd., Tokyo 141-8560 (JP)
(72) Inventor: INADA, Yoshikatsu, Fujisawa-shi Kanagawa 251-8501 (JP); TAGAMI, Kotaro, Fujisawa-shi Kanagawa 251-8501 (JP); SEKINE, Takaaki, Tokyo 141-8560 (JP)
(74) Representative: Klingseisen, Franz
(86) International application number: PCT/JP2014/006200
(87) International publication number: WO 2015/087554

(56) References cited:
- WO-A1-2013/111277
- JP-A- 2011 030 405
- US-A1- 2012 160 596
- US-A1- 2013 069 493

## Description

### Technical Field

The present invention relates to an electronic control unit (ECU: Electronic Control Unit), an electric power steering, and a vehicle, in particular, to an electronic control unit configured to control driving of an electric motor, an electric power steering device using the same, and a vehicle in which the electric power steering is equipped.

### Background Art

The electronic control unit in the electric power steering device equipped in a vehicle controls driving of the electric motor, and includes a power module equipped with switching elements, and a control board on which a control device of controlling an output current from the power module is implemented. The power module is electrically connected with the electric motor via an output connector, and the control board is electrically connected with the battery and the torque sensor of the vehicle.

In this situation, even if an abnormality occurs at the switching element (switching means) of the power module in the ECU of driving the electric motor, there is a demand for continuing of the driving of the electric motor.

To meet this demand, the electric power steering device of Patent Literature 1 is conventionally proposed.

In the electric power steering device of Patent Literature 1, multi-phase motor winding of the electric motor is duplicated, for example, and each of inverter units supplies the electric current to each of the duplicated multi-phase motor windings. That is, a first inverter unit supplies the electric current to one of the multi-phase motor windings, whereas a second inverter unit supplies the electric current to the other one of the multi-phase motor windings.

A prior art according to US 2012/0160596 A1 describes an electronic control unit for an electric power steering device including an electric motor and in which the control unit controls the motor based on a torque signal indicative of a steering torque. This control unit comprises first and second power modules as well as a control board and an input and output board. It is an object of this known electric control unit to provide electric motor assembly which is compact in size and is possible to perform accurate control of the electric motor.

Then, when the switching means (i.e., switching element) of one of the inverter units (e.g., the first inverter unit) encounters an off failure to be non-conductive, that is an open failure, the switching means suffering from the failure is identified, the switching means other than the failed switching means is controlled, and the normal inverter unit (e.g., the second inverter unit) is controlled other than the failed inverter unit (e.g., the first inverter unit) including the failed switching means.

### Citation List

### Patent Literature

PLT 1: JP 4998836 B

### Summary

### Technical Problem

The above-described electric power steering device of PLT 1, however, has a following drawback.

That is, PLT 1 does not disclose at all anything about the actual wiring from the first inverter unit that supplies the electric current to one of the multi-phase motor windings, or the actual wiring from the second inverter unit that supplies the electric current to the other one of the multi-phase motor windings.

In detail, PLT 1 does not disclose at all a pattern configuration connecting from the first and second inverter units to the electric motor in the circuit board connected with the first and second inverter units, or does not disclose the output connector configuration at all. Hence, depending on the pattern configuration or the three-phase output connector configuration, the power loss from the output units of the first and second inverter units to the electric current joining point might be increased.

Accordingly, the present invention has been made to address the above drawbacks, and has an object to provide an electronic control unit configured to control driving of an electric motor, an electric power steering device using the same, and a vehicle in which the electric power steering is equipped. In the electronic control unit, by designing the pattern configuration and the connector configuration of an input and output board to be connected with two power modules including first and second power modules on each of which switching elements are mounted, the power loss from output terminals of the first and second power modules to electric current joining points can be suppressed.

### Solution to Problem

In order to address the above drawback, according to one aspect of the present invention, there is provided an electronic control unit including: first and second power modules on which switching elements are respectively mounted; an input and output board on which an input connector and an output connector to be connected to an electric motor are mounted, and which is connected with the first and second power modules; and a control board on which a controller configured to control output currents from the first and second power modules. First and second conductor patterns respectively connected with output terminals of the first and second power modules and extending independently of each other are formed in the input and output board, and a terminal is mounted on the output connector, the terminal including: an output terminal portion to be connected to the electric motor; and first and second board connection portions extending from the output terminal portion to be respectively connected to the first and second conductor patterns.

In addition, in the above-described electronic control unit, the first and second conductor patterns may be arranged to be line-symmetric when the first and second conductor patterns are viewed from a plane of the input and output board.

Further, in the above-described electronic control unit, a first output terminal of the first power module may include a first A-phase output terminal, a first B-phase output terminal, and a first C-phase output terminal respectively corresponding to an A phase, a B phase, and a C phase of the electric motor, a second output terminal of the second power module may include a second A-phase output terminal, a second B-phase output terminal, and a second C-phase output terminal respectively corresponding to the A phase, the B phase, and the C phase of the electric motor, the first conductor pattern may include a first A-phase conductor pattern connected with and extending from the first A-phase output terminal of the first power module, a first B-phase conductor pattern connected with and extending from the first B-phase output terminal of the first power module, and a first C-phase conductor pattern connected with and extending from the first C-phase output terminal of the first power module, and the second conductor pattern may include a second A-phase conductor pattern connected with and extending from the second A-phase output terminal of the first power module, a second B-phase conductor pattern connected with and extending from the second B-phase output terminal of the first power module, and a second C-phase conductor pattern connected with and extending from the second C-phase output terminal of the first power module.

Further, in the above-described electronic control unit, the terminal may include an A-phase terminal, a B-phase terminal, and a C-phase terminal respectively corresponding to the A phase, the B phase, and the C phase of the electric motor, the A-phase terminal may include the output terminal portion, the first board connection portion to be connected to the first A-phase conductor pattern, and the second board connection portion to be connected to the second A-phase conductor pattern, the B-phase terminal may include the output terminal portion, the first board connection portion to be connected to the first B-phase conductor pattern, and the second board connection portion to be connected to the second B-phase conductor pattern, and the C-phase terminal may include the output terminal portion, the first board connection portion to be connected to the first C-phase conductor pattern, and the second board connection portion to be connected to the second C-phase conductor pattern.

Furthermore, in the above-described electronic control unit, the A-phase terminal, the B-phase terminal, and the C-phase terminal may be insert-molded to be insulated from each other and overlap each other, when a housing is formed.

Moreover, in the above-described electronic control unit, the first and second board connection portions of the A-phase terminal, the first and second board connection portions of the B-phase terminal, and the first and second board connection portions of the C-phase terminal may be arranged to be line-symmetric when viewed from a plane of the output connector.

In addition, according to another aspect of the present invention, there is provided an electric power steering device including any one of the above-described electronic control units.

Further, according to yet another aspect of the present invention, there is provided a vehicle including the above-described electric power steering device.

### Advantageous Effects

According to an electronic control unit, an electric power steering device, and a vehicle in one embodiment of the present invention, first and second conductor patterns are provided to be respectively connected with output terminals of first and second power modules and extend independently of each other, such that motor drive currents respectively output from the output terminals of the first and second power modules flow in two lines across the first and second conductor patterns independently of each other in the input and output board. In addition, the output connector includes a terminal including an output terminal portion to be connected to the electric motor, and first and second board connection portions extending from the output terminal portion to be connected respectively to the first and second conductor patterns. Hence, the motor drive currents flow across the first and second conductor patterns in two lines independently of each other, then flow through the first and second board connection portions of the terminal independently of each other, and join at the output terminal portion to be connected to the electric motor. Therefore, the motor drive currents join at the output terminal portions closest to the electric motor. This configuration makes longer the distances between the output terminals of the first and second power modules and the electric current joining point than the distance in a case where the electric currents are joined on the input and output board. Hence, the power loss from the first and second power modules to the electric current joining point is suppressed. Since the power loss is proportional to the square of the electric current value, a shorter distance through which such a heavy current flows after the electric currents are joined may be desirable.

### Brief Description of Drawings

FIG. 1 is a view of a basic configuration of an electric power steering device in which an electronic control unit operating as a motor controller in some embodiments of the present invention;
FIG. 2 is a block diagram illustrating a control system of the motor controller of the electric power steering device illustrated in FIG. 1;
FIG. 3 is an exploded perspective view of an inner configuration of the electric control unit operating as the motor controller;
FIG. 4 is a perspective view of an outer configuration of the electric control unit;
FIG. 5 is a first side view of the electric control unit when viewed from an arrow L1 direction;
FIG. 6 is a second side view of the electric control unit when viewed from an arrow L2 direction;
FIG. 7 is a perspective view of a power module of FIG. 3;
FIG. 8 is a view of the power module when viewed from an arrow L3 direction of FIG. 7;
FIG. 9 is a cross-sectional view schematically illustrating an outline configuration of a housing;
FIG. 10 is a perspective view of an input and output board of the electric control unit on which a power supply input connector, a three-phase output connector, and electronic parts (i.e., discrete parts) are mounted;
FIG. 11 is a front view of the input and output board when viewed from an arrow L4 direction of FIG. 10;
FIG. 12 is a side view of the input and output board when viewed from an arrow L5 direction of FIG. 10 (i.e., an identical direction to the arrow L1 direction);
FIG. 13A is a plan view of an A-phase terminal included in a terminal used for the three-phase output connector, when viewed in an arrow L6 direction of FIG. 10;
FIG. 13B is a side view of the A-phase terminal included in the terminal used for the three-phase output connector, when viewed in the arrow L5 direction of FIG. 10;
FIG. 13C is a front view of the A-phase terminal included in the terminal used for the three-phase output connector, when viewed in the arrow L4 direction of FIG. 10;
FIG. 14A is a plan view of a B-phase terminal included in the terminal used for the three-phase output connector, when viewed in the arrow L6 direction of FIG. 10;
FIG. 14B is a side view of the B-phase terminal included in the terminal used for the three-phase output connector, when viewed in the arrow L5 direction of FIG. 10;
FIG. 14C is a front view of the B-phase terminal included in the terminal used for the three-phase output connector, when viewed in the arrow L4 direction of FIG. 10;
FIG. 15A is a plan view of a C-phase terminal included in the terminal used for the three-phase output connector, when viewed in the arrow L6 direction of FIG. 10;
FIG. 15B is a side view of the C-phase terminal included in the terminal used for the three-phase output connector, when viewed in the arrow L5 direction of FIG. 10;
FIG. 15C is a front view of the C-phase terminal included in the terminal used for the three-phase output connector, when viewed in the arrow L4 direction of FIG. 10;
FIG. 16 is a perspective view of the input and output board and the control board connected by first and second power modules, and the power supply input connector, the three-phase output connector, and the electronic parts (i.e., discrete parts) illustrated in FIG. 10 are mounted on the input and output board;
FIG. 17 is a plan view of the input and output board and the control board when viewed from an arrow L8 direction of FIG. 16 (i.e., an identical direction to the arrow L6 direction); and
FIG. 18 is a side view of the input and output board and the control board when viewed from an arrow L7 direction of FIG. 16 (i.e., an identical direction to the arrow L5 direction).

### Description of Embodiments

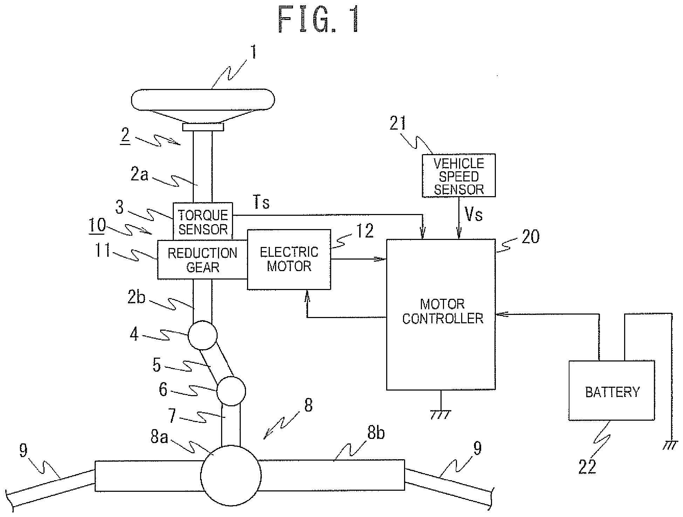

Hereinafter, embodiments of the present invention will be described with reference to the accompanied drawings. FIG. 1 is a view of a basic configuration of an electric power steering device in which an electronic control unit operating as a motor controller in some embodiments of the present invention.

The electric power steering device illustrated in FIG. 1 is equipped in a vehicle like an automobile. In such an electric power steering device, a steering force exerted by a driver to a steering wheel 1 is transmitted to a steering shaft 2. The steering shaft 2 includes an input shaft 2a and an output shaft 2b. One end of the input shaft 2a is coupled with the steering wheel 1, whereas the other end thereof is coupled through a steering torque sensor 3 with the outer end of the output shaft 2b.

Then, the steering force that has been transmitted to the output shaft 2b is transmitted via a universal joint 4 to a lower shaft 5, and is further transmitted to a pinion shaft 7 via a universal joint 6. The steering force that has been transmitted to the pinion shaft 7 is transmitted to a tie rod 9 via a steering gear 8, so that turning wheels, not illustrated, are made to turn. Here, the steering gear 8 is configured to be a rack and pinion form including a pinion 8a connected with the pinion shaft 7 and a rack 8b engaging with the pinion 8a, and the rotational motion that has been transmitted to the pinion 8a is converted at the rack 8b into the straight motion of the vehicle widthwise direction.

The output shaft 2b of the steering shaft 2 is coupled with a steering assistance mechanism 10 that transmits a steering assistance force to the output shaft 2b. The steering assistance mechanism 10 includes a reduction gear 11 including, for example, a worm gear mechanism connected with the output shaft 2b, and an electric motor 12 operating as the electric motor including, for example, a three-phase brushless motor producing the steering assistance force and connected with the reduction gear 11.

The steering torque sensor 3 detects steering torque exerted onto the steering wheel 1 and then transmitted to the input shaft 2a. The steering torque sensor 3, for example, converts the steering torque into a twisting angular displacement of a torsion bar (not illustrated) arranged between the input shaft 2a and the output shaft 2b, and to convert the twisting angular displacement into an angle difference between an input-side rotational angle sensor (not illustrated) arranged on the input shaft 2a side and an output side rotational angle sensor (not illustrated) arranged on the output shaft 2b side.

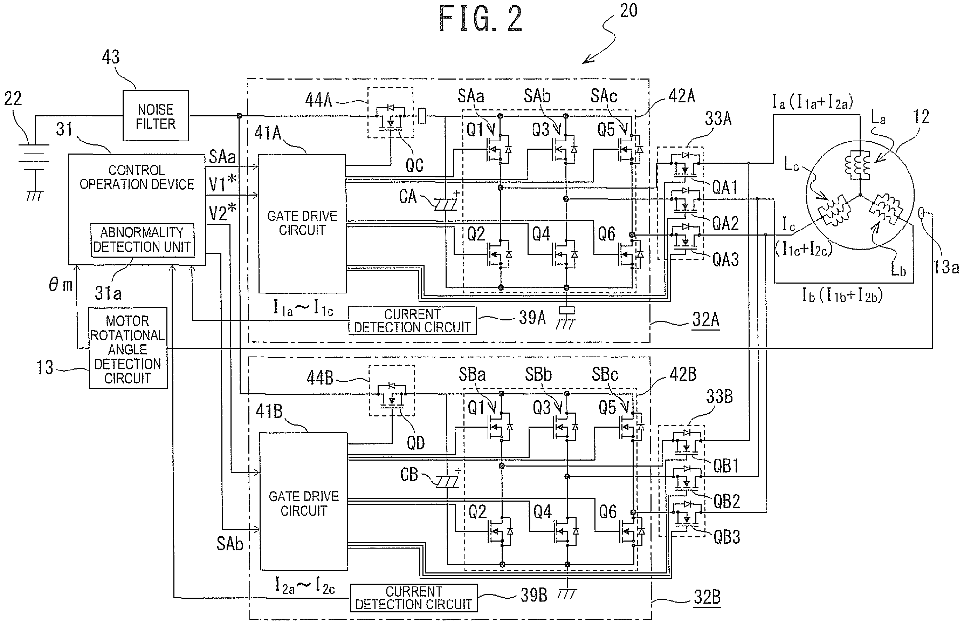

In addition, the electric motor 12 is configured with, for example, a three-phase brushless motor, and as illustrated in FIG. 2, motor windings La, Lb, and, Lc of A phase, B phase, and C phase of the three phases are respectively wound around slots of the stator. One ends of the motor windings La, Lb, and Lc of the respective phases are connected together to form a star connection, whereas the other ends of the motor windings La, Lb, and Lc of the respective phases are connected with a motor controller 20, so that motor drive currents la, Ib, and Ic are individually supplied.

The electric motor 12, as illustrated in FIG. 2, includes a rotational position sensor 13a configured to detect the rotational position of the motor. The detection value from the rotational position sensor 13a is supplied to a motor rotational angle detection circuit 13, so that the motor rotational angle detection circuit 13 detects a motor rotational angle θm.

In addition, a direct current is input into the motor controller 20 from a battery 22 operating as a direct current power source.

Herein, as illustrated in FIG. 2, the motor controller 20 includes a control operation device 31 configured to operate three-phase voltage instruction values V1* and V2*, first and second motor drive circuits 32A and 32B into which the three-phase motor voltage instruction values V1* and V2* output from the control operation device 31 are individually input, and first and second motor current cutoff circuits 33A and 33B respectively arranged between the first and second motor drive circuits 32A and 32B and the motor windings La, Lb, and Lc of the respective phases of the electric motor 12.

The control operation device 31 receives a steering torque detected by the steering torque sensor 3, a vehicle speed detected by a vehicle speed sensor 21, and a motor rotational angle θm output from the motor rotational angle detection circuit 13, a motor angular velocity, and a motor angular acceleration. In addition, the control operation device 31 receives motor drive currents I1a to I1c and I2a to I2c, output from current detection circuits 39A and 39B, and supplied to the motor windings La, Lb, and Lc of the respective phases of the electric motor 12. Then, the control operation device 31 calculates the three-phase voltage instruction values V1* and V2* corresponding to the first and second motor drive circuits 32A and 32B based on the steering torque, the vehicle speed, the motor rotational angle θm, the motor angular velocity, and the motor angular acceleration, and then outputs the calculated three-phase voltage instruction values V1* and V2* to gate drive circuits 41A and 41B, as will be described later, of the first and second motor drive circuits 32A and 32B.

Then, the control operation device 31 includes an abnormality detection unit 31a configured to detect an open failure of the upper arms and a short-circuit failure of the lower arms of field effect transistors (FET) Q1 to Q6 operating as switching elements included in first and second inverter circuits 42A and 42B, as will be described later, and a disconnection abnormality of any of the coil units of the motor windings La, Lb, and Lc of the respective phases of the electric motor 12. When the abnormality detection unit 31a does not detect an open failure or a short-circuit failure of the field effect transistors (FET) Q1 to Q6, the abnormality detection unit 31a outputs failure detection signals SAa and SAb of logical values "0" (normality) to the gate drive circuits 41A and 41B of the first and second motor drive circuits 32A and 32B, whereas when the abnormality detection unit 31a detects the open failure and the short-circuit failure of the field effect transistors (FET) Q1 to Q6, the abnormality detection unit 31a outputs a failure detection signals SAa or SAb of a logical value "1" (abnormality) to the gate drive circuit 41A or 41B of the first and second motor drive circuit 32A or 32B where the abnormality has been detected.

Each of the first and second motor drive circuits 32A and 32B receives the three-phase voltage instruction values V1* and V2* output from the control operation device 31, and forms a gate signal, and includes gate drive circuits 41A and 41B also operating as abnormality time current controllers, and first and second inverter circuits 42A and 42B that receive gate signals output from the gate drive circuits 41A and 41B.

Here, when the failure detection signal SAa input from the control operation device 31 is the logical value "0" (normality), the gate drive circuit 41A is configured to output three gate signals of high level to the motor current cutoff circuit 33A, and output the gate signal of high level to a power cutoff circuit 44A. In addition, when the failure detection signal SAa is the logical value "1" (abnormality), the gate drive circuit 41A is configured to output three gate signals of low level to the motor current cutoff circuit 33A at the same time to cut off motor drive currents I1a to I1c, and output the gate signal of low level to the power cutoff circuit 44A to cut off a battery current.

Similarly, when the failure detection signal SAa input from the control operation device 31 is the logical value "0" (normality), the gate drive circuit 41B is configured to output three-gate signals of high level to the motor current cutoff circuit 33B, and output the gate signal of high level to a power cutoff circuit 44B. In addition, when the failure detection signal SAa is the logical value "1" (abnormality), the gate drive circuit 41B is configured to output three gate signals of low level to the motor current cutoff circuit 33B at the same time to cut off motor drive currents I2a to I2c, and output the gate signal of low level to the power cutoff circuit 44B to cut off a battery current.

Further, each of the first and second inverter circuits 42A and 42B receives a battery current of a battery 22 through a noise filter 43 and the power cutoff circuits 44A and 44B, and is respectively connected on the input side with electrolytic capacitors CA and CB for smoothing.

Then, each of the first and second inverter circuits 42A and 42B includes six field effect transistors (FETs) Q1 to Q6 operating as switching elements, and has a configuration in which three switching arms SAa, SAb, and SAc are connected in parallel and two FETs are connected in series in each of three switching arms SAa, SAb, and SAc. Then, the FETs Q1 to Q6 included in the first inverter circuit 42A receive the gate signals output from the gate drive circuit 41A, and the motor drive current I1a of A phase, the motor drive current I1b of B phase, and the motor drive current I1c of C phase are supplied from between the FETs in each of the switching arms SAa, SAb, and SAc through the motor current cutoff circuit 33A to the motor windings La, Lb, and Lc of the respective phases of the electric motor 12. Further, the FETs Q1 to Q6 included in the second inverter circuit 42B receive gate signals output from the gate drive circuit 41B, and the motor drive current I2a of A phase, the motor drive current I2b of B phase, and the motor drive current I2c of C phase are electrically conductive from between the FETs in each of the switching arms SAa, SAb, and SAc through the motor current cutoff circuit 33B to the motor windings La, Lb, and Lc of the respective phases of the electric motor 12.

It is to be noted that the motor current cutoff circuit 33A includes three FETs QA1 to QA3 for cutting off the current, and the motor current cutoff circuit 33B includes three FETs QB1 to QB3 for cutting off the current.

Then, the source of the FET QA1 of the motor current cutoff circuit 33A is connected with a connection point of transistors Q1 and Q2 of the switching arm SAa of the first inverter circuit 42A, and the drain of the FET QA1 is connected with the A-phase motor winding La of the electric motor 12. Further, the source of the FET QA2 is connected with a connection point of transistors Q3 and Q4 of the switching arm SAb of the first inverter circuit 42A, and the drain of FET QA2 is connected with the B-phase motor winding Lb of the electric motor 12. Furthermore, the source of the FET QA3 is connected with a connection point of transistors Q5 and Q6 of the switching arm SAc of the first inverter circuit 42A, and the drain of the FET QA3 is connected with the C-phase motor winding Lc of the electric motor 12.

In addition, the source of the FET QB1 of the motor current cutoff circuit 33B is connected with a connection point of the transistors Q1 and Q2 of the switching arm SBa of the second inverter circuit 42B, and the drain of the FET QB1 is connected with the A-phase motor winding La of the electric motor 12. Further, the source of the FET QB2 is connected with a connection point of the transistors Q3 and Q4 of the switching arm SBb of the second inverter circuit 42B, and the drain of the FET QB2 is connected to the B-phase motor winding Lb of the electric motor 12. Furthermore, the source of the FET QB3 is connected with a connection point of the transistors Q5 and Q6 of the switching arm SBc of the second inverter circuit 42B, and the drain of the FET QB3 is connected to the C-phase motor winding Lc of the electric motor 12.

Thus, wiring from the drain of the FET QA1 of the motor current cutoff circuit 33A and wiring from the drain of the FET QB1 of the motor current cutoff circuit 33B are connected and joined with the A-phase motor winding La of the electric motor 12. Also, wiring from the drain of FET QA2 of the motor current cutoff circuit 33A and wiring from the drain of FET QB2 of the motor current cutoff circuit 33B are connected and joined with the B-phase motor winding Lb of the electric motor 12. Further, wiring from the drain of the FET QA3 of the motor current cutoff circuit 33A and wiring from the drain of the FET QB3 of the motor current cutoff circuit 33B are connected and joined with the C-phase motor winding Lc of the electric motor 12.

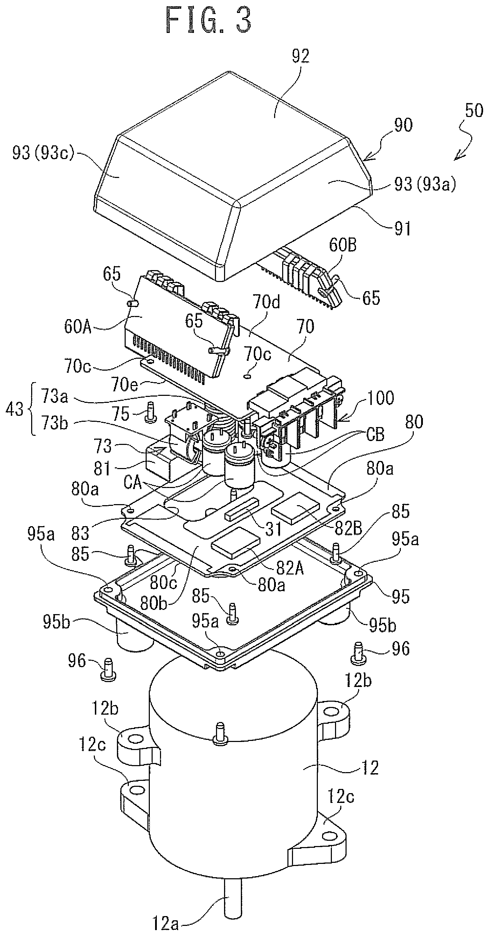

Next, a configuration of an electronic control unit 50 operating as the motor controller 20 will be described by using FIG. 3 to FIG. 9.

In FIG. 3 to FIG. 9, mainly, the electronic control unit 50 includes first and second power modules 60A and 60B, an input and output board 70, a control board 80, and a housing 90 configured to accommodate them.

The first power module 60A includes the motor current cutoff circuit 33A, a first inverter circuit 42A including plural switching elements, and a power cutoff circuit 44A. The second power module 60B includes, mainly, the motor current cutoff circuit 33B, a second inverter circuit 42B including plural switching elements, and a power cutoff circuit 44B.

The input and output board 70 includes a power supply input connector (an input connector) 71 to which the power is input, a three-phase output connector (an output connector) 100 of making an output to the electric motor 12, and electronic parts (discrete parts) 73 such as electrolytic capacitors CA and CB, coils 73a and 73b included in a noise filter 43, resistors, and a three-terminal regulator 73.

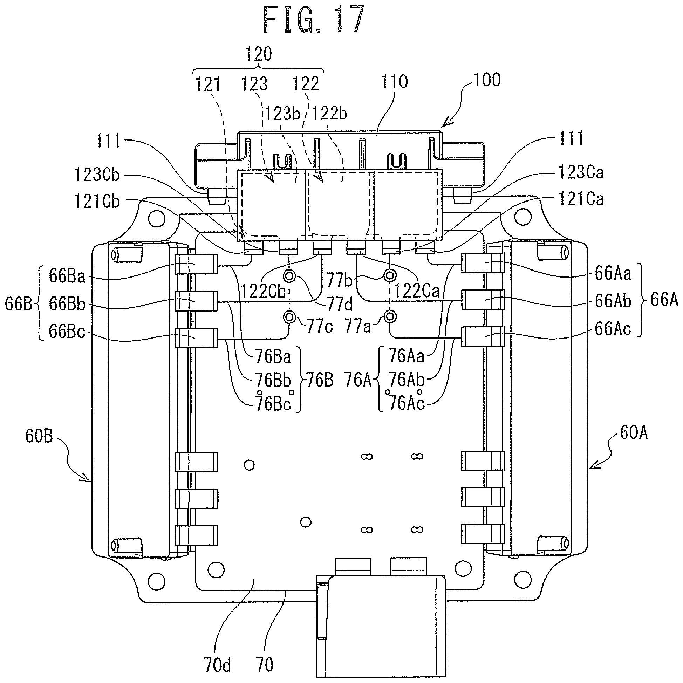

The control board 80 includes the control operation device 31 operating as a controller of controlling output currents from the first and second power modules 60A and 60B, a gate drive device 82A equipped with the gate drive circuit 41A, a gate drive device 82B equipped with the gate drive circuit 41B, and electronic parts such as capacitors, resistors, and a signal input connector 81. The input and output board 70 has a multilayer interconnection structure in which wiring layers are arranged on, for example, a top face 70d and a bottom face 70e, or on the top face 70d, the bottom face 70e, and an inner layer. The control board 80 has a multilayer interconnection structure in which wiring layers are arranged, for example, on a top face 80b and a bottom face 80c, or on the top face 80b, the bottom face 80c, and an inner layer. The interconnection structure extending between output terminals 66A and 66B of the first and second power modules 60A and 60B in the input and output board 70 (see FIG. 17) and the three-phase output connector 100 will be described later in detail.

The housing 90 mainly includes a case 91 and a cover 95, such that the first and second power modules 60A and 60B, the input and output board 70, and the control board 80 are accommodated in an accommodation portion including the case 91 and the cover 95. The case 91 and the cover 95 are made of an electrically conductive material, for example, Aluminum Die Cast (ADC).

The case 91 has a depressed shape including a ceiling 92, a side wall 93 integrally arranged at the edge of the ceiling 92 to surround the center of the ceiling 92, and an opening portion arranged on the opposite side to the ceiling 92. The cover 95 is attached to cover the opening portion. The case 91 is formed to have a substantially rectangular shape in a plane view, and includes four side walls 93 (93a, 93b, 99c, and 93d). In the four side walls 93a, 93b, 93c, and 93d, the two side walls 93a and 93b face each other in a first direction (left-right direction), and the other two side walls 93c and 93d face each other in a second direction (front-rear direction) perpendicular to the first direction.

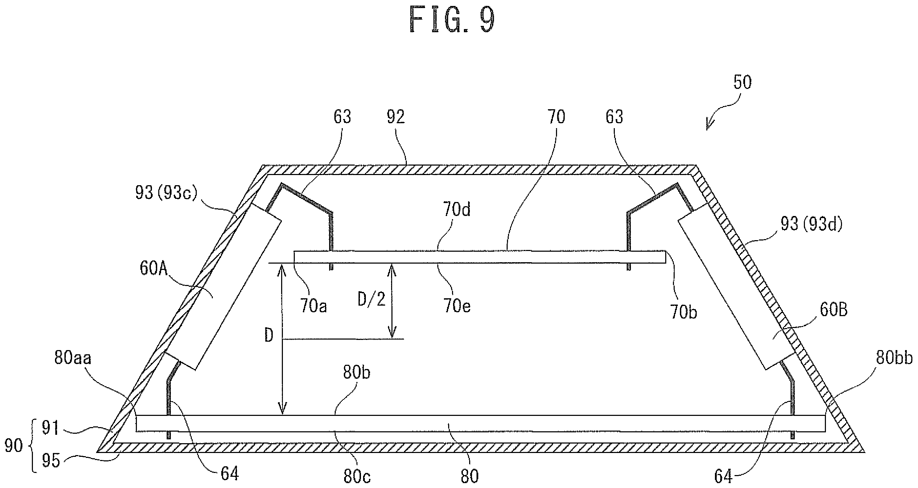

The first and second power modules 60A and 60B are individually screwed and secured to the two side walls 93c and 93d facing each other of the case 91 with screw members 65 from the inside. In addition, the input and output board 70 is screwed and secured to the ceiling 92 of the case 91 with a screw member 75 from the inside. Further, the control board 80 is screwed and secured to the ceiling 92 of the case 91 with screw members 85 from the inside. Furthermore, the cover 95 is screwed and secured to the side walls 93a, 93b, 93c, and 93d of the case 91 with screw members 96 from its outer side. The input and output board 70 and the control board 80 face each other with a predetermined space D (see FIG. 9) in a thickness direction of the electronic control unit 50, that is an up-down direction. In FIG. 3, the input and output board 70 is arranged above the control board 80 with the top being set to "up" and the bottom being set to "down".

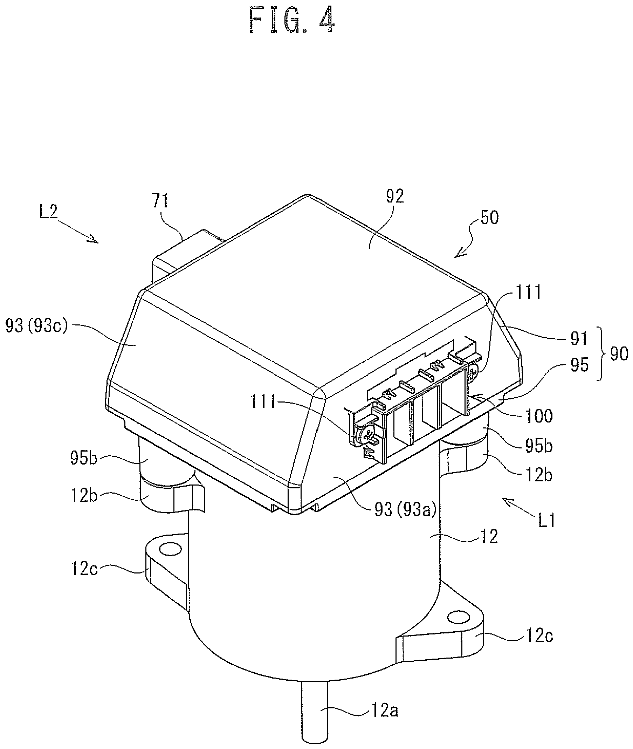

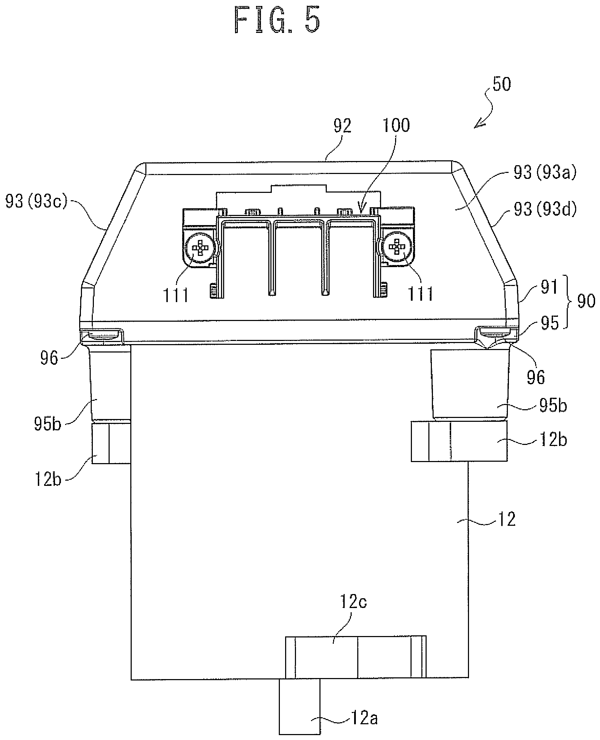

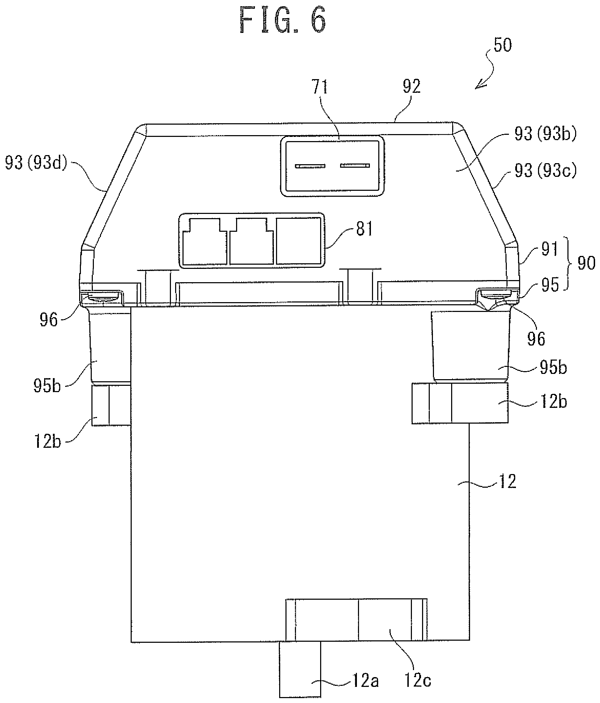

The three-phase output connector 100 mounted on the input and output board 70 is exposed outwardly from the side wall 93a of the case 91 (see FIG. 4 and FIG. 5). In addition, the power supply input connector 71 of the input and output board 70 and the signal input connector 81 of the control board 80 are exposed outwardly from the side wall 93b of the case 91 (see FIG. 6). A detailed configuration of the three-phase output connector 100 will be described later.

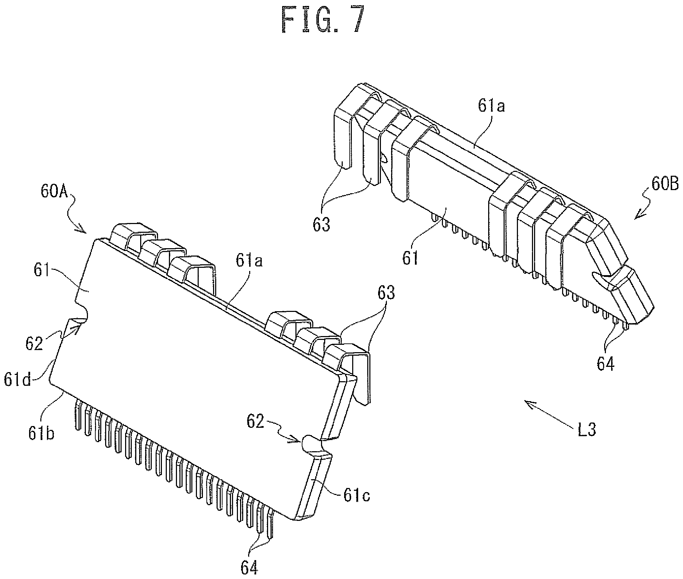

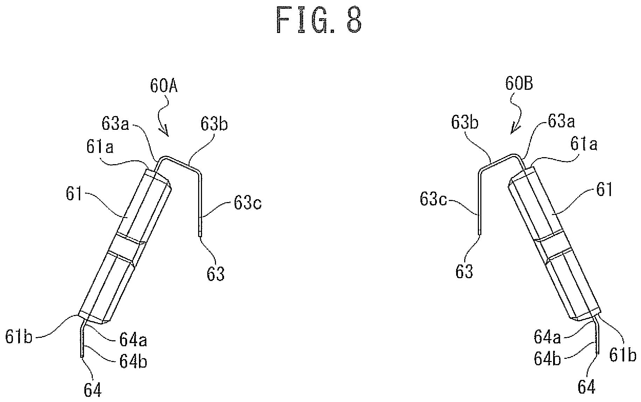

As illustrated in FIG. 7 and FIG. 8, each of the first and second power modules 60A and 60B includes a seal body 61, plural first leads 63, and plural second leads 64. Each of the first and second power modules 60A and 60B has a package structure of a bidirectional lead array type.

The seal body 61 is formed to have a rectangular plane shape in a plane view, and is formed in rectangular having, for example, two long sides 61a and 61b and two short sides 61c and 61d in one embodiment of the present invention. The seal body 61 is made of, for example, an insulating resin or ceramics. The seal body 61 of the first power module 60A mainly seals the switching elements included in the first inverter circuit 42A. The seal body 61 of the second power module 60B mainly seals the switching elements included in the second inverter circuit 42B.

Plural first and second leads 63 and 64 are not illustrate in detail, but they extend over the inside and outside of the seal body 61, and includes an inner lead part located at the inside of the seal body 61 and an outer lead part located at the outside of the seal body 61.

Each of the plural first leads 63 extends along one long side 61a of two long sides 61a and 61b of the seal body 61, at the outer lead part located at the outside of the seal body 61. Each of plural second leads 64 along the other one long side 61b of the two long sides 61a and 61b of the seal body 61, at the outer lead part located at the outside of the seal body 61.

Each of the plural first and second leads 63 and 64 is formed by bending in plural steps at the outer lead part located at the outside of the seal body 61.

Each of the outer lead parts of the plural first leads 63 is formed by bending, for example, in three steps, including a first part 63a that protrudes from one long side 61a of the seal body 61, a second part 63b that bends in a thickness direction of the seal body 61 from the first part 63a, and a third part 63c that bends to a back face side of the seal body 61 from this second part 63b.

Each of the outer lead parts of the plural second leads 64 is formed by bending, for example, in two steps, including a first part 64a that protrudes from the other long side 61b of the seal body 61, and a second part 64b that bends to slant toward a back face side of the seal body 61 from the first part 64a.

In the first and second power modules 60A and 60B, each of the plural first leads 63 are, for example, soldered onto the wiring of the input and output board 70 and connected electrically and mechanically. In addition, each of the plural second leads 64 are, for example, soldered onto the wiring of the control board 80 and connected electrically and mechanically.

Here, the plural first leads 63 include the first lead 63 electrically connected to a terminal of the power supply input connector 71 and the first lead 63 electrically connected to a terminal of the three-phase output connector 100, through electric wiring of the input and output board 70. In addition, the plural second leads 64 include the second lead 64 electrically connected to a terminal of the signal input connector 81 through electric wiring of the control board 80.

It is to be noted that the first lead 63 electrically connected to the terminal of the three-phase output connector 100 in the first power module 60A operates as an output terminal 66A of the first power module 60A (see FIG. 17), and the first lead 63 electrically connected to the terminal of the three-phase output connector 100 in the second power module 60B operates as an output terminal 66B of the second power module 60B (see FIG. 17).

The electronic control unit 50 configured as described above is attached at an end face on the opposite side of an output shaft 12a of the electric motor 12, and is screwed and secured with a screw member, not illustrated. On the bottom face of the cover 95 included in the electronic control unit 50, as illustrated in FIG. 3 to FIG. 6, plural boss portions 95b are formed to protrude. In attaching the electronic control unit 50 onto the electric motor 12, the boss portions 95b are mounted on plural first attachment flange portions 12b arranged on the electric motor 12, and in addition, the bottom face of the cover 95 is mounted on an end face on the opposite side to the output shaft 12a. Then, by screwing and securing the first attachment flange portions 12b and the boss portions 95b with screw members, not illustrated, the electronic control unit 50 is attached onto the electric motor 12. It is to be noted that plural second attachment flange portions 12c for attaching other members are provided on the output shaft 12a side of the electric motor 12.

Next, a manufacturing method (assembling method) of the electronic control unit 50 will be described with reference to FIG. 3.

Firstly, the first and second power modules 60A and 60B, the input and output board 70, the control board 80, the case 91, and the cover 95 are prepared. On the input and output board 70, the electronic parts (discrete parts) 73 such as the power supply input connector 71, the three-phase output connector 100, the electrolytic capacitors CA and CB, the coils 73a and 73b included in the noise filter 43, the resistors, and the three-terminal regulator are mounted. On the control board 80, electronic parts such as the control device (control operation device 31) that controls output currents from the first and second power modules 60A and 60B, and the gate drive device (gate drive circuits 41A and 41B) are mounted. Further, the electronic parts such as the capacitors, the resistors, and the signal input connector 81 are mounted.

Next, the first and second power modules 60A and 60B are individually screwed and secured onto the side walls 93c and 93d of the case 91 with screw members 65 from the inside.

Then, the input and output board 70 is screwed and secured onto the ceiling 92 of the case 91 with the screw members 75 from the inside. The input and output board 70 includes plural screw through holes 70c. In screwing and securing, the screw members 75 are respectively inserted through the screw through holes 70c. In addition, when the input and output board 70 is screwed and secured onto the ceiling 92 of the case 91, plural first leads 63 of the first and second power modules 60A and 60B are inserted into through holes (not illustrated) arranged in the wiring of the input and output board 70.

Next, the control board 80 is screwed and secured onto the ceiling 92 of the case 91 with the screw members 85 from the inside. The control board 80 includes plural screw through holes 80a. In screwing and securing, the screw members 85 are respectively inserted into the screw through holes 80a. Further, when the control board 80 is screwed and secured onto the ceiling 92 of the case 91, the plural second leads 64 of the first and second power modules 60A and 60B are inserted into through holes (not illustrated) arranged in the wiring of the control board 80.

Then, plural first leads 63 of the first and second power modules 60A and 60B are electrically and mechanically connected to the through holes arranged in the input and output board 70 by soldering, and at the same time, the plural second leads 64 of the first and second power modules 60A and 60B are electrically and mechanically connected to the through holes arranged in the control board 80 by soldering.

Then, the cover 95 is attached to cover the opening of the case 91, and is screwed and secured to the side wall 93 of the case 91 with screw members 96 from the outside of the cover 95. Plural screw through holes 95a are arranged in the cover 95, and in screwing and securing, the screw members 96 are respectively inserted into the through holes 95a.

Accordingly, the electronic control unit 50 in one embodiment of the present invention is almost produced.

In the electronic control unit 50, as illustrated in FIG. 9, the input and output board 70 and the control board 80 are arranged to face each other with a predetermined space D in a direction of the thickness of the electronic control unit 50, that is in the up-down direction. In one embodiment of the present invention, the input and output board 70 is arranged closer to the ceiling 92 of the case 91 than to the control board 80, the control board 80 is arranged closer to the cover 95 than to the input and output board 70, that is, arranged on the lower side.

The input and output board 70 is formed to have a plane size that is smaller than the plane size of the control board 80. The input and output board 70 has two sides 70a and 70b facing each other, and the control board 80 has two sides 80aa and 80bb facing each other.

One side 70a of the input and output board 70 is located on the same side with one side 80aa of the control board 80, and is located on an inner side than the one side 80aa. The other side 70b of the input and output board 70 is located on the same side with the other side 80bb of the control board 80, and is located on an inner side than the other side 80bb.

The first power module 60A is arranged to intersect one side 70a of the input and output board 70 on the one sides 70a and 80aa side of the input and output board 70 and the control board 80. The second power module 60B is arranged to intersect one side 70b of the input and output board 70 on the other sides 70b and 80bb side of the input and output board 70 and the control board 80.

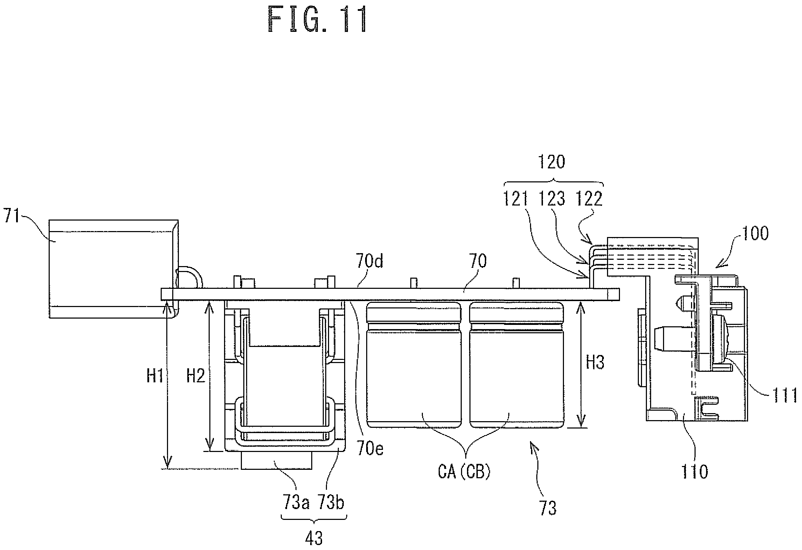

As described above, the electronic parts 73 mounted on the input and output board 70 are discrete parts including, for example, electrolytic capacitors CA and CB, the coils 73a and 73b included in the noise filter 43, the resistors, and the three-terminal regulators. Among these discrete parts, the electrolytic capacitors CA and CB, the coils 73a and 73b included in the noise filter 43 are relatively higher electronic parts 73. In other words, a height H1 of the coil 73a, a height H2 of the coil 73b, and a height H3 of the electrolytic capacitors CA and CB, which are the electronic parts 73 considered to be relatively high, as illustrated in FIG. 11, are larger than a half, which is D/2, a distance D between the input and output board 70 and the control board (see FIG. 9).

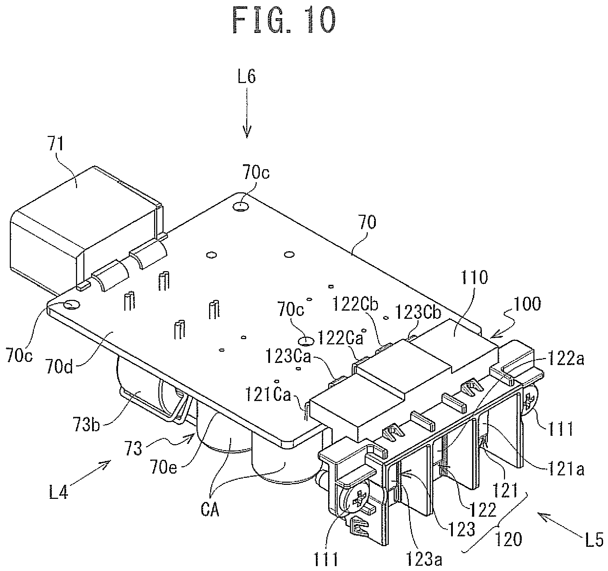

The discrete parts such as the coils 73a and 73b and the electrolytic capacitors CA and CB, which are the electronic parts 73 considered to be relatively high are mounted only on a face of the input and output board 70 facing the control board 80, that is, only on the bottom face 70e of the input and output board 70. As illustrated in FIG. 10 and FIG. 11, the electronic parts 73 are not mounted on a top face 70d of the input and output board 70, the top face 80b of the control board 80, or the bottom face 80c of the control board 80.

Thus, the discrete parts which are the electronic parts 73 considered to be relatively high are mounted only on a face of the input and output board 70 facing the control board 80, that is, only on the bottom face 70e of the input and output board 70. Accordingly, the height size of the electronic control unit 50 can be lowered without limiting the mounting arrangement of the input and output board 70 or the control board 80 facing each other in the up-down direction.

In other words, by mounting the discrete parts that are electronic parts 73 considered to be relatively high on a face (the bottom face 70e) of the input and output board 70 facing the control board 80, a space between the input and output board 70 and the control board 80 can be utilized for the mounting of the discrete parts of the electronic parts 73 considered to be relatively high, and the size of the electronic control unit 50 can be lowered. Also, when the arrangements of the above-described discrete parts are divided into the face (the bottom face 70e) of the input and output board 70 facing the control board 80 and the face (the top face 80b) of the control board 80 facing the input and output board 70, the height of the electronic control unit 50 can be lowered. However, such a configuration brings an inconvenience of limiting the mounting arrangements of the input and output board 70 and the control board 80 in order to avoid a contact between the discrete parts arranged on both of the input and output board 70 and the control board 80.

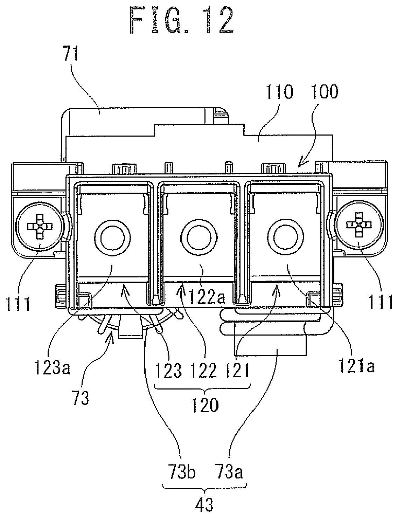

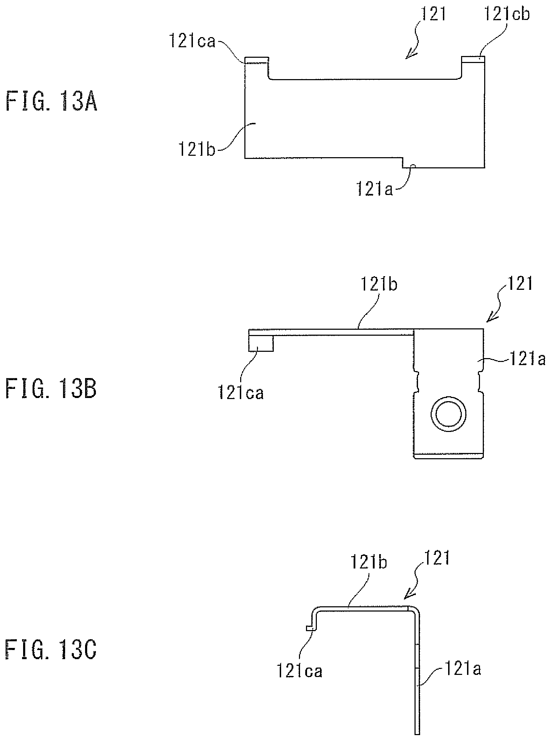

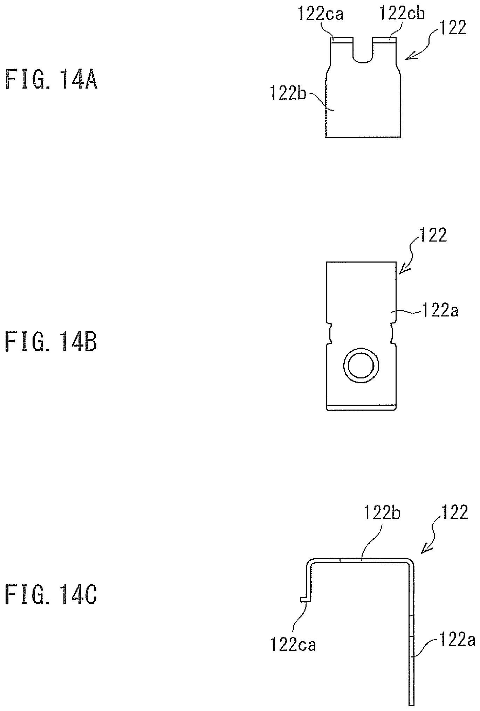

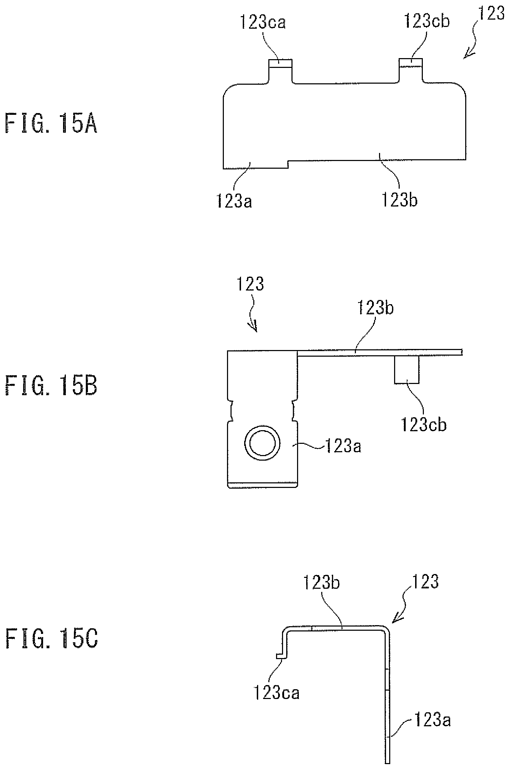

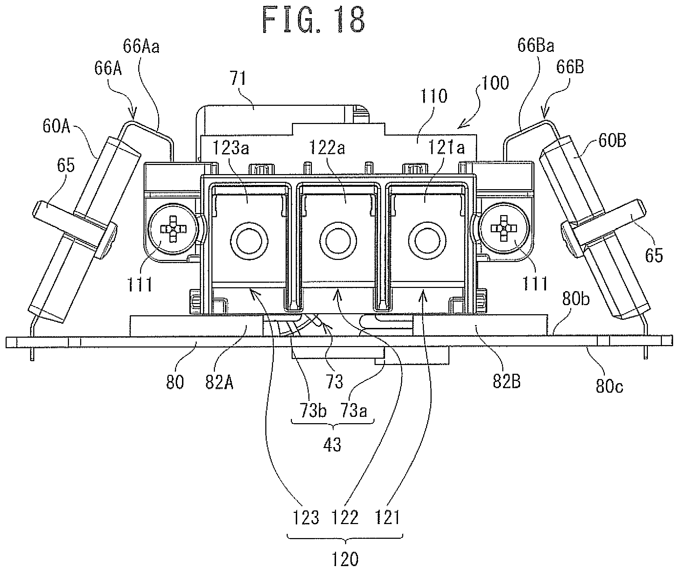

Next, configurations of the output terminals 66A and 66B of the first and second power modules 60A and 60B in the input and output board 70, wiring structures between the output terminals 66A and 66B and the three-phase output connector 100, and a configuration of the three-phase output connector 100 will be described with reference to FIG. 10 to FIG. 18.

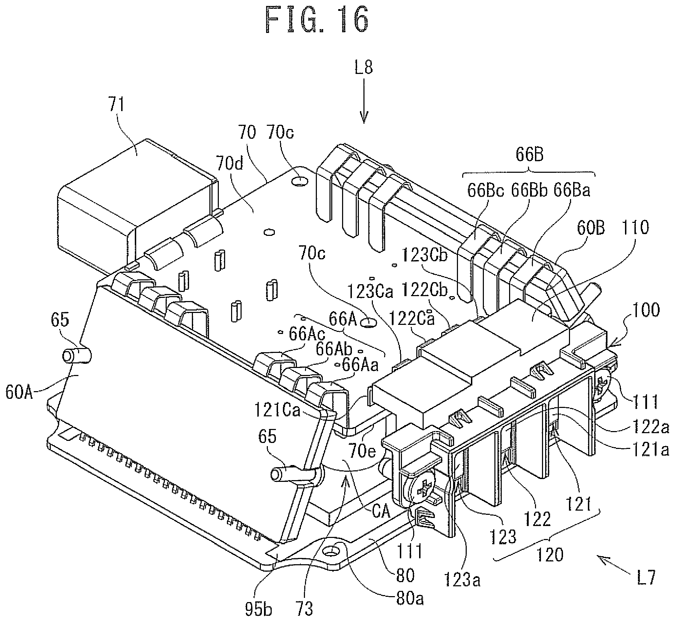

Firstly, the output terminal 66A of the first power module, as illustrated in FIG. 16 and FIG. 17, includes a first A-phase output terminal 66Aa, a first B-phase output terminal 66Ab, and a first C-phase output terminal 66Ac, respectively corresponding to the A phase, B phase, and C phase of the electric motor 12. In addition, the output terminal 66B of the second power module 60B, as illustrated in FIG. 16 and FIG. 17, includes a second A-phase output terminal 66Ba, a second B-phase output terminal 66Bb, and a second C-phase output terminal 66Bc, respectively corresponding to the A phase, B phase, and C phase of the electric motor 12.

Further, first and second conductor patterns 76A and 76B are formed on the input and output board 70, as illustrated in FIG. 17, such that the first and second conductor patterns 76A and 76B are respectively connected to the output terminals 66A and 66B of the first and second power modules 60A and 60B, and extend independently of each other.

Here, the first and second conductor patterns 76A and 76B are arranged to be line-symmetric when viewed from a plane face of the input and output board 70.

Then, the first conductor pattern 76A includes a first A-phase conductor pattern 76Aa connected with and extending from the first A-phase output terminal 66Aa of the first power module 60A, a first B-phase conductor pattern 76Ab connected with and extending from the first B-phase output terminal 66Ab of the first power module 60A, and a first C-phase conductor pattern 76Ac connected with and extending from the first C-phase output terminal 66Ac of the first power module 60A.

Here, the first A-phase conductor pattern 76Aa extends on a top face of the input and output board 70 from the first A-phase output terminal 66Aa to a first board connection portion 121ca of the A phase terminal 121 of the three-phase output connector 100.

In addition, the first B-phase conductor pattern 76Ab extends on the top face of the input and output board 70 from the first B-phase output terminal 66Ab to a first board connection portion 122ca of the B phase terminal 122 of the three-phase output connector 100.

Further, the first C-phase conductor pattern 76Ac extends on the top face 70d of the input and output board 70 from the first C-phase output terminal 66Ac to the bottom face 70e of the input and output board 70 through the first through hole 77a so as not to interfere with the first B-phase conductor pattern 76Ab, extends to the second through hole 77b on the bottom face 70e of the input and output board 70, then extends to the top face 70d of the input and output board 70 through the second through hole 77b, and further extends on the top face 70d of the input and output board 70 to a first board connection portion 123ca of the C phase terminal 123 of the three-phase output connector 100.

In addition, the second conductor pattern 76B includes, a second A-phase conductor pattern 76Ba connected with and extending from the first A-phase output terminal 66Ba of the second power module 60B, a second B-phase conductor pattern 76Bb connected with and extending from the second B-phase output terminal 66Bb of the second power module 60B, and a second C-phase conductor pattern 76Bc connected with and extending from the second C-phase output terminal 66Bc of the second power module 60B.

Here, the second A-phase conductor pattern 76Ba extends on the top face of the input and output board 70, from the second A-phase output terminal 66Ba to a second board connection portion 121cb of the A phase terminal 121 of the three-phase output connector 100.

In addition, the second B-phase conductor pattern 76Bb extends on the top face of the input and output board 70 from the second B-phase output terminal 66Bb to a second board connection portion 122cb of the B phase terminal 122 of the three-phase output connector 100.

Further, the second C-phase conductor pattern 76Bc extends on the top face 70d of the input and output board 70 from the second C-phase output terminal 66Bc to the bottom face 70e of the input and output board 70 through the third through hole 77c so as not to interfere with the second B-phase conductor pattern 76Bb, extends to the fourth through hole 77d on the bottom face 70e of the input and output board 70, then extends to the top face 70d of the input and output board 70 through the fourth through hole 77d, and further extends on the top face 70d of the input and output board 70 to a second board connection portion 123cb of the C phase terminal 123 of the three-phase output connector 100.

The three-phase output connector 100 electrically conducts an A-phase motor drive current I1a, a B-phase motor drive current I1b, and a C-phase motor drive current I1c, which are output currents from the first power module 60A, with the motor windings La, Lb, and Lc of the respective phases of the electric motor 12, and also electrically conducts an A-phase motor drive current I2a, a B-phase motor drive current I2b, and a C-phase motor drive current I1c, which are output currents from the second power module 60B, with the motor windings La, Lb, and Lc of the respective phases of the electric motor 12. Therefore, a connector (not illustrated) connected with electric wires (not illustrated) respectively connected with the motor windings La, Lb, and Lc of the respective phases of the electric motor 12 is configured to be mated with three-phase output connector 100.

The three-phase output connector 100, as illustrated in FIG. 10 to FIG. 12, and FIG. 16 to FIG. 18, includes an insulating housing 110, and terminals 120 secured to the housing 110. The terminals 120 includes an A-phase terminal 121, a B-phase terminal 122, and a C-phase terminal 123, respectively corresponding to the A phase, B phase, and C phase of the electric motor 12. When the housing 110 is molded, the A-phase terminal 121, the B-phase terminal 122, and the C-phase terminal 123 are insert-molded to be insulated from each other and overlap each other from bottom to top in an order of the A-phase terminal 121, the C-phase terminal 123, and the B-phase terminal 122 as illustrated in FIG. 11.

Here, as illustrated in FIG. 10, FIG. 12, FIG. 13A, FIG. 13B, and FIG. 13C, the A-phase terminal 121 includes an output terminal portion 121a having a substantially rectangular shape extending in the up-down direction to be connected to the electric motor 12, a coupling portion 121b having a substantially rectangular shape bending from an upper end of the output terminal portion 121a and extending frontward and in a left direction, and first and second board connection portions 121ca and 121cb extending downwardly from front edges of both of left and right ends of the coupling portion 121b (edges on an opposite side to the edges from which the output terminal portion 121a extends). The first and second board connection portions 121ca and 121cb of the A-phase terminal 121 are arranged to be line-symmetric when viewed from a plane face of the output connector 100. The A-phase terminal 121 is made by stamping and bending a conductive metal plate.

In addition, as illustrated in FIG. 10, FIG. 12, FIG. 14A, FIG. 14B, and FIG. 14C, the B-phase terminal 122 includes an output terminal portion 122a having a substantially rectangular shape extending in the up-down direction to be connected to the electric motor 12, a coupling portion 122b having a substantially rectangular shape bending from an upper end of the output terminal portion 122a and extending frontward, and first and second board connection portions 122ca and 122cb extending downwardly from front edges of both of left and right ends of the coupling portion 122b. The B-phase terminal 122 is made by stamping and bending a conductive metal plate. The first and second board connection portions 122ca and 122cb are arranged to be line-symmetric when viewed from a plane face of the output connector 100, and in addition, are arranged on inner sides than the first and second board connection portions 121ca and 121cb of the A-phase terminal 121, as illustrated in FIG. 17.

Further, as illustrated in FIG. 10, FIG. 12, FIG. 15A, FIG. 15B, and FIG. 15C, the C-phase terminal 123 includes an output terminal portion 123a having a substantially rectangular shape extending in the up-down direction to be connected to the electric motor 12, a coupling portion 123b having a substantially rectangular shape bending from an upper end of the output terminal portion 123a and extending frontward and in a right direction, and first and second board connection portions 123ca and 123cb extending downwardly from front edges on both of left and right sides of the coupling portion 123b (edges on an opposite side to the edges from which the output terminal portion 123a extends). The C-phase terminal 123 is made by stamping and forming a conductive metal plate. The first and second board connection portions 123ca and 123cb are arranged to be line-symmetric when viewed from a plane face of the output connector 100, and in addition, arranged on inner sides than the first and second board connection portions 121ca and 121cb of the A-phase terminal 121 and on outer sides than the first and second board connection portions 122ca and 122cb of the B-phase terminal 122, as illustrated in FIG. 17.

The first board connection portion 121ca of the A-phase terminal 121, the first board connection portion 122ca of the B-phase terminal 122, and the first board connection portion 123ca of the C-phase terminal 123 are connected to the first conductor pattern 76A of the input and output board 70. In addition, the second board connection portion 121cb of the A-phase terminal 121, the second board connection portion 122cb of the B-phase terminal 122, and the second board connection portion 123cb of the C-phase terminal 123 are connected to the second conductor pattern 76B of the input and output board 70.

To be specific, the first board connection portion 121ca of the A-phase terminal 121 is connected by soldering with a first A-phase conductor pattern 76Aa, the first board connection portion 122ca of the B-phase terminal 122 is connected by soldering with a first B-phase conductor pattern 76Ab, and the first board connection portion 123ca of the C-phase terminal 123 is connected by soldering with the first C-phase conductor pattern 76Ac.

Also, the second board connection portion 121cb of the A-phase terminal 121 is connected by soldering with the second A-phase conductor pattern 76Ba, the second board connection portion 122cb of the B-phase terminal 122 is connected by soldering with the second B-phase conductor pattern 76Bb, and the second board connection portion 123cb of the C-phase terminal 123 is connected by soldering with the second C-phase conductor pattern 76Bc.

In addition, the three-phase output connector 100 is attached to the side wall 93a of the case 91 with a pair of left and right attachment screw members 111, as illustrated in FIG. 4.

In the electronic control unit 50 having the above configuration, the first and second conductor patterns 76A and 76B are formed on the input and output board 70 to be connected with the respective output terminals 66A and 66B of the first and second power modules 60A and 60B, and then to extend independently of each other. Accordingly, the motor drive currents output from the respective output terminals 66A and 66B of the first and second power modules 60A and 60B are flowed on the input and output board 70 through the first and second conductor patterns 76A and 76B in two lines independently of each other. The terminals 120 (121, 122, and 123) are mounted on the output connector 100. The terminals 120 include the output terminal portions 121a, 122a, and 123a to be connected to the electric motor 12, and the first board connection portions 121ca, 122ca, and 123ca and the second board connection portions 121cb, 122cb, and 123cb, respectively extending from the output terminal portions 121a, 122a, and 123a and connected to the first and second conductor patterns 76A and 76B. Accordingly, the motor drive currents flow through the first and second conductor patterns 76A and 76B in two lines independently of each other, flow through the first board connection portions 121ca, 122ca, and 123ca and the second board connection portions 121cb, 122cb, and 123cb of the terminals 120 (121, 122, and 123) independently of each other, and join together at the output terminal portions 121a, 122a, and 123a to the electric motor 12, to be specific, at the coupling portions 121b, 122b, and 123b. Accordingly, the motor driver currents join together at the output terminal portions 121a, 122a, and 123a that are closest to the electric motor 12, so that distances from the output terminals 66A and 66B of the first and second power modules 60A and 60B to the electric current joining point can be made longer than the case where the electric currents are joined together on the input and output board 70. This configuration enables suppression of power loss from the two output terminals 66A and 66B of the first and second power modules 60A and 60B to the electric current joining point. Since the power loss is proportional to the square of the current value, a shorter distance through which the heavy-current after the electric currents are joined together flows through may be desirable.

Specifically, the motor drive current output from the first A-phase output terminal 66Aa of the first power module 60A flows through the first A-phase conductor pattern 76Aa, and the motor drive current output from the second A-phase output terminal 66Ba of the second power module 60B flows through the second A-phase conductor pattern 76Ba. Then, the motor drive current that has flowed through the first A-phase conductor pattern 76Aa and the motor drive current that has flowed through the second A-phase conductor pattern 76Ba respectively flow across the first board connection portion 121ca and the second board connection portion 121cb of the A-phase terminal 121 independently of each other, and join together at the coupling portion 121b.

Further, the motor drive current output from the first B-phase output terminal 66Ab of the first power module 60A flows through the first B-phase conductor pattern 76Ab, and the motor drive current output from the second B-phase output terminal 66Bb of the second power module 60B flows through the second B-phase conductor pattern 76Bb. Then, the motor drive current that has flowed through the first B-phase conductor pattern 76Ab and the motor drive current that has flowed through the second B-phase conductor pattern 76Bb respectively flow across the first board connection portion 122ca and the second board connection portion 122cb of the B-phase terminal 122 independently of each other, and join together at the coupling portion 122b.

Furthermore, the motor drive current output from the first C-phase output terminal 66Ac of the first power module 60A flows through the first C-phase conductor pattern 76Ac, and the motor drive current output from the second C-phase output terminal 66Bc of the second power module 60B flows through the second C-phase conductor pattern 76Bc. Then, the motor drive current that has flowed through the first C-phase conductor pattern 76Ac and the motor drive current that has flowed through the second C-phase conductor pattern 76Bc respectively flow across the first board connection portion 123ca and the second board connection portion 123cb of the C-phase terminal 123 independently of each other, and join together at the coupling portion 123b.

Thus, the respective distances from output terminals 66A and 66B of the first and second power modules 60A and 60B to the joining point of the electric currents can be made longer than the case where the electric currents are joined together on the input and output board 70. This configuration enables the suppression of the power loss from the two output terminals 66A and 66B of the first and second power modules 60A and 60B to the joining point of the electric currents.

In addition, since the first board connection portion 121ca of the A-phase terminal 121 is connected by soldering with the first A-phase conductor pattern 76Aa and the second board connection portion 121cb of the A-phase terminal 121 is connected by soldering with the second A-phase conductor pattern 76Ba, even if one of the board connection portions is incompletely connected, the A-phase motor drive current flows, as long as the other one of the board connection portions is connected properly. Further, this phenomenon also applies to the B-phase terminal 122 and the C-phase terminal 123. Accordingly, advantages of a redundant electric join between the electronic control unit 50 and the electric motor 12 is also obtainable.

In addition, the first and second conductor patterns 76A and 76B are arranged to be line-symmetric when viewed from a plane face of the input and output board 70. This configuration allows a simple configuration of the input and output board 70.

Further, the first conductor pattern 76A includes the first A-phase conductor pattern 76Aa connected with and extending from the first A-phase output terminal 66Aa of the first power module 60A, the first B-phase conductor pattern 76Ab connected with and extending from the first B-phase output terminal 66Ab of the first power module 60A, and the first C-phase conductor pattern 76Ac connected with and extending from the first C-phase output terminal 66Ac of the first power module 60A. Also, the second conductor pattern 76B includes the second A-phase conductor pattern 76Ba connected with and extending from the second A-phase output terminal 66Ba of the second power module 60B, the second B-phase conductor pattern 76Bb connected with and extending from the second B-phase output terminal 66Bb of the second power module 60B, and the second C-phase conductor pattern 76Bc connected with and extending from the second C-phase output terminal 66Bc of the second power module 60B. Accordingly, this configuration enables the wiring of the conductor patterns corresponding to the three-phase electric motor 12 of A phase, B phase, and C phase.

Further, the terminal 120 includes the A-phase terminal 121, the B-phase terminal 122, and the C-phase terminal 123, respectively corresponding to the A phase, B phase, and C phase of the electric motor 12. The A-phase terminal 121 includes the output terminal portion 121a, the first board connection portion 121ca to be connected to the first A-phase conductor pattern 76Aa, and the second board connection portion 121cb to be connected to the second A-phase conductor pattern 76Ba. The B-phase terminal 122 includes the output terminal portion 122a, the first board connection portion 122ca to be connected to the first B-phase conductor pattern 76Ab, and the second board connection portion 122cb to be connected to the second B-phase conductor pattern 76Bb. Furthermore, the C-phase terminal 123 includes the output terminal portion 123a, the first board connection portion 123ca to be connected to the first C-phase conductor pattern 76Ac, and the second board connection portion 123cb to be connected to the second C-phase conductor pattern 76Bc. Therefore, a terminal configuration corresponding to the three-phase electric motor 12 of the A phase, B phase, and C phase is achievable.

Moreover, the first and second board connection portions 121ca and 121cb of the A-phase terminal 121, the first and second board connection portions 122ca and 122cb of the B-phase terminal 122, and the first and second board connection portions 123ca and 123cb of the C-phase terminal 123 are arranged to be line-symmetric when viewed from a plane face of the output connector 100. This configuration easily achieves the arrangements of the first and second conductor patterns 76A and 76B to be line-symmetric when viewed from a plane face of the input and output board 70.

The embodiments of the present invention have been described heretofore, but, the present invention is not limited to the above embodiments. Various changes and improvements are applicable.

For example, the first and second conductor patterns 76A and 76B formed in the input and output board 70 may be configured such that the motor drive currents are flowed independently of each other, and are not limited to those illustrated in FIG. 17.

Also, an insert molding board that eliminates the need for through-holes may be applicable to the input and output board 70.

In addition, the arrangements and shapes of the A-phase terminal 121, the B-phase terminal 122, and the C-phase terminal 123 included in the terminal 120 can be configured such that each of the A-phase terminal 121, the B-phase terminal 122, and the C-phase terminal 123 is insulated from each other, and the output terminal portion to be connected to the electric motor 12 and the first and second board connection portions respectively connected with the first and second conductor patterns 76A and 76B extending from the output terminal portion are provided. The arrangements and shapes are not limited to those illustrated in FIG. 10 to FIG. 18.

Further, in each of the A-phase terminal 121, the B-phase terminal 122, and the C-phase terminal 123, the first and second board connection portions 121ca, 121cb, 122ca, 122cb, 123ca, and 123cb may directly extend from the output terminal portions 121a, 122a, and 123a, without extending from the coupling portions 121b, 122b, and 123b.

Furthermore, the terminal 120 does not necessarily include the A-phase terminal 121, the B-phase terminal 122, or the C-phase terminal 123, and may be a single terminal.

### Reference Signs List

1 ... steering wheel, 2 ... steering shaft, 2a ... input shaft, 2b ... output shaft, 3 ... steering torque sensor, 4 ... universal joint, 5 ... lower shaft, 6 ... universal joint portion, 7 ... pinion shaft, 8 ... steering gear, 8a ... pinion, 8b ... rack, 9 ... tie rod, 10 ... steering assistance mechanism, 11 ... reduction gear, 12 ... electric motor, 12a ... output shaft, 12b ... first flange portion, 12c ... second flange portion, 13 ... motor rotational angle detection circuit, 13a ... rotational position sensor, La ... A-phase motor winding, Lb ... B-phase motor winding, Lc ... C-phase motor winding, 20 ... motor controller, 21 ... speed sensor, 22 ... battery, 31 ... control operation device, 32A ... first motor drive circuit, 32B ... second motor drive circuit, 33A ... first motor current cutoff circuit, 33B ... second motor current cutoff circuit, 39A, 39B ... current detection circuit, 41A, 41B ... gate drive circuit, 42A, 42B ... inverter circuit, 43 ... noise filter, 44A, 44B ... power cutoff circuit, 50 ... electronic control unit, 60A ... first power module, 60B ... second power module, 61 ... seal body, 61a, 61b ... long side, 61c, 61d ... short side, 63 ... first lead, 63a ... first part, 63b ... second part, 63c ... third part, 64 ... second lead, 64a ... first part, 64b ... second part, 65 ... screw member, 66A ... output terminal of the first power module, 66Aa ... first A-phase output terminal, 66Ab ... first B-phase output terminal, 66Ac ... first C-phase output terminal, 66B ... output terminal of the second power module, 66Ba ... second A-phase output terminal, 66Bb ... second B-phase output terminal, 66Bc ... second C-phase output terminal, 70 ... input and output board, 70c ... screw through hole, 70d ... top face of the input and output board, 70e ... bottom face of the input and output board, 71 ... power supply input connector (input connector), 73 ... electronic part (discrete part), 73a ... coil, 73b ... coil, 75 ... screw member, 76A ... first conductor pattern, 76Aa ... first A-phase conductor pattern, 76Ab ... first B-phase conductor pattern, 76Ac ... first C-phase conductor pattern, 76B ... second conductor pattern, 76Ba ... second A-phase conductor pattern, 76Bb ... second B-phase conductor pattern, 76Bc ... second C-phase conductor pattern, 77a ... first through hole, 77b ... second through hole, 77c ... third through hole, 77d ... fourth through hole, 80 ... control board, 80a ... screw through holes, 80b ... top face of the control board, 80c ... bottom face of the control board, 81 ... signal input connector, 82A ... gate drive device, 82B ... gate drive device, 83 ... opening, 85 ... screw member, 90 ... housing, 91 ... case, 92 ... ceiling, 93a, 93b, 93c, 93d ... side wall, 95 ... cover, 95a ... screw through hole, 95b ... boss portion, 96 ... screw member, 100 ... three-phase output connector (output connector), 110 ... housing, 120 ... terminal, 121 ... A-phase terminal, 121a ... output terminal portion, 121b ... coupling portion, 121ca ... first board connection portion, 121cb ... second board connection portion, 122 ... B-phase terminal, 122a ... output terminal portion, 122b ... coupling portion, 122ca ... first board connection portion, 122cb ... second board connection portion, 123 ... C-phase terminal, 123a ... output terminal portion, 123b ... coupling portion, 123ca ... first board connection portion, 123cb ... second board connection portion

## Claims

1. An electronic control unit (50) comprising:
first and second power modules (60A; 60B) on which switching elements are respectively mounted;
an input and output board (70) on which an input connector (71) and an output connector (100) to be connected to an electric motor (12) are mounted, and which is connected with the first and second power modules (60A; 60B); and
a control board (80) on which a controller is mounted, the controller being configured to control output currents from the first and second power modules (60A; 60B),
**characterized in that**
first and second conductor patterns (76A; 76B) respectively connected with output terminals (66A; 66B) of the first and second power modules (60A; 60B) and extending independently of each other are formed in the input and output board (70), and **in that**
a terminal (120) is mounted on the output connector (100), the terminal (120) comprising:
an output terminal portion (121a) to be connected to the electric motor (12); and
first and second board connection portions (121ca; 121cb) extending from the output terminal portion (121a) to be respectively connected to the first and second conductor patterns (76A; 76B).

2. The electronic control unit (50) according to claim 1, wherein the first and second conductor patterns (76A; 76B) are arranged to be line-symmetric when the first and second conductor patterns (76A; 76B) are viewed from a plane of the input and output board (70).

3. The electronic control unit (50) according to claim 1 or claim 2,
wherein a first output terminal (66A) of the first power module comprises a first A-phase output terminal, a first B-phase output terminal, and a first C-phase output terminal respectively corresponding to an A phase, a B phase, and a C phase of the electric motor (12),
wherein a second output terminal (66B) of the second power module comprises a second A-phase output terminal, a second B-phase output terminal, and a second C-phase output terminal respectively corresponding to the A phase, the B phase, and the C phase of the electric motor (12),
wherein the first conductor pattern (76A) comprises a first A-phase conductor pattern connected with and extending from the first A-phase output terminal of the first power module (60A), a first B-phase conductor pattern connected with and extending from the first B-phase output terminal (66A) of the first power module, and a first C-phase conductor pattern connected with and extending from the first C-phase output terminal of the first power module (60A), and
wherein the second conductor pattern (76B) comprises a second A-phase conductor pattern connected with and extending from the second A-phase output terminal of the second power module (60B), a second B-phase conductor pattern connected with and extending from the second B-phase output terminal of the second power module (60B), and a second C-phase conductor pattern connected with and extending from the second C-phase output terminal of the second power module (60B).

4. The electronic control unit (50) according to claim 3,
wherein the terminal comprises an A-phase terminal (121), a B-phase terminal (122), and a C-phase terminal (123) respectively corresponding to the A phase, the B phase, and the C phase of the electric motor (12),
wherein the A-phase terminal (121) comprises the output terminal portion (121a), the first board connection portion to be connected to the first A-phase conductor pattern, and the second board connection portion to be connected to the second A-phase conductor pattern,
wherein the B-phase terminal (122) comprises the output terminal portion, the first board connection portion to be connected to the first B-phase conductor pattern, and the second board connection portion to be connected to the second B-phase conductor pattern, and
wherein the C-phase terminal (123) comprises the output terminal portion, the first board connection portion to be connected to the first C-phase conductor pattern, and the second board connection portion to be connected to the second C-phase conductor pattern.

5. The electronic control unit (50) according to claim 4, wherein the A-phase terminal, the B-phase terminal, and the C-phase terminal are insert-molded to be insulated from each other and overlap each other, when a housing (90; 100) is formed.

## Patentansprüche

1. Elektronische Steuereinheit (50), umfassend:
ein erstes und ein zweites Leistungsmodul (60A; 60B), auf denen jeweils Schaltelemente angebracht sind;
eine Eingangs- und Ausgangsplatine (70), auf der ein Eingangsverbinder (71) und ein Ausgangsverbinder (100), die mit einem Elektromotor (12) zu verbinden sind, angebracht sind, und die mit dem ersten und dem zweiten Leistungsmodul (60A; 60B) verbunden ist; und
eine Steuerplatine (80), auf der eine Steuerung angebracht ist, wobei die Steuerung konfiguriert ist, um Ausgangsströme von dem ersten und dem zweiten Leistungsmodul (60A; 60B) zu steuern,
**dadurch gekennzeichnet, dass**
ein erstes und ein zweites Leitermuster (76A; 76B), die jeweils mit Ausgangsanschlüssen (66A; 66B) des ersten und des zweiten Leistungsmoduls (60A; 60B) verbunden sind und sich unabhängig voneinander erstrecken, in der Eingangs- und Ausgangsplatine (70) ausgebildet sind,
und das
ein Anschluss (120) an dem Ausgangsverbinder (100) angebracht ist, wobei der Anschluss (120) umfasst:
einen Ausgangsanschlussabschnitt (121a), der mit dem Elektromotor (12) zu verbinden ist; und
einen ersten und einen zweiten Plattenverbindungsabschnitt (121ca; 121cb), die sich von dem Ausgangsanschlussabschnitt (121a) erstrecken, um jeweils mit dem ersten und dem zweiten Leitermuster (76A; 76B) zu verbinden sind.

2. Elektronische Steuereinheit (50) nach Anspruch 1, wobei das erste und das zweite Leitermuster (76A; 76B) liniensymmetrisch angeordnet sind, wenn das erste und das zweite Leitermuster (76A; 76B) von einer Ebene der Eingabe- und Ausgabeplatine (70) aus betrachtet werden.

3. Elektronische Steuereinheit (50) nach Anspruch 1 oder Anspruch 2,
wobei ein erster Ausgangsanschluss (66A) des ersten Leistungsmoduls einen ersten A-Phasenausgangsanschluss, einen ersten B-Phasenausgangsanschluss und einen ersten C-Phasenausgangsanschluss umfasst, die jeweils einer A-Phase, einer B-Phase und eine C-Phase des Elektromotors (12) entsprechen,
wobei ein zweiter Ausgangsanschluss (66B) des zweiten Leistungsmoduls einen zweiten A-Phasenausgangsanschluss, einen zweiten B-Phasenausgangsanschluss und einen zweiten C-Phasenausgangsanschluss umfasst, die jeweils der A-Phase, der B-Phase und der C-Phase des Elektromotors (12) entsprechen,
wobei das erste Leitermuster (76A) ein erstes A-Phasen-Leitermuster, das mit dem ersten A-Phasen-Ausgangsanschluss des ersten Leistungsmoduls (60A) verbunden ist und sich von diesem erstreckt, ein erstes B-Phasen-Leitermuster, das mit dem ersten B-Phasen-Ausgangsanschluss (66A) des ersten Leistungsmoduls verbunden ist und sich von diesem erstreckt, und ein erstes C-Phasen-Leitermuster umfasst, das mit dem ersten C-Phasen-Ausgangsanschluss des ersten Leistungsmoduls (60A) verbunden ist und sich von diesem erstreckt; und
wobei das zweite Leitermuster (76B) ein zweites A-Phasen-Leitermuster, das mit dem zweiten A-Phasen-Ausgangsanschluss des zweiten Leistungsmoduls (60B) verbunden ist und sich von diesem erstreckt, ein zweites B-Phasen-Leitermuster, das mit dem zweiten B-Phasen-Ausgangsanschluss des zweiten Leistungsmoduls (60B) verbunden ist und sich von diesem erstreckt, und ein zweites C-Phasen-Leitermuster umfasst, das mit dem zweiten C-Phasen-Ausgangsanschluss des zweiten Leistungsmoduls (60B) verbunden ist und sich von diesem erstreckt.

4. Elektronische Steuereinheit (50) nach Anspruch 3,
wobei der Anschluss einen A-Phasenanschluss (121), einen B-Phasenanschluss (122) und einen C-Phasenanschluss (123) umfasst, die jeweils der A-Phase, der B-Phase und der C-Phase des Elektromotors (12) entsprechen,
wobei der A-Phasenanschluss (121) den Ausgangsanschlussabschnitt (121a), den ersten Platinenverbindungsabschnitt, der mit dem ersten A-Phasenleitermuster zu verbinden ist, und den zweiten Platinenverbindungsabschnitt, der mit dem zweiten A-Phasenleitermuster zu verbinden ist, umfasst,
wobei der B-Phasenanschluss (122) den Ausgangsanschlussabschnitt, den ersten Platinenverbindungsabschnitt, der mit dem ersten B-Phasenleitermuster zu verbinden ist, und den zweiten Platinenverbindungsabschnitt, der mit dem zweiten B-Phasenleitermuster zu verbinden ist, umfasst, und
wobei der C-Phasenanschluss (123) den Ausgangsanschlussabschnitt, den ersten Platinenverbindungsabschnitt, der mit dem ersten C-Phasenleitermuster zu verbinden ist, und den zweiten Platinenverbindungsabschnitt, der mit dem zweiten C-Phasenleitermuster zu verbinden ist, umfasst.

5. Elektronische Steuereinheit (50) nach Anspruch 4, wobei der A-Phasenanschluss, der B-Phasenanschluss und der C-Phasenanschluss einsatzgeformt werden, um voneinander isoliert zu sein, wenn ein Gehäuse (90; 100) geformt wird.

## Revendications

1. Unité de commande électronique (50) comprenant :
des premier et second modules de puissance (60A ; 60B) sur lesquels sont respectivement montés des éléments de commutation ;
une carte d'entrée et de sortie (70) sur laquelle sont montés un connecteur d'entrée (71) et un connecteur de sortie (100) à connecter à un moteur électrique (12), et qui est connectée aux premier et second modules de puissance (60A ; 60B) ; et
une carte de commande (80) sur laquelle est monté un contrôleur, le contrôleur étant configuré de manière à commander des courants de sortie en provenance des premier et second modules de puissance (60A ; 60B),
**caractérisée en ce que** :
des premier et second tracés conducteurs (76A ; 76B) connectés respectivement à des bornes de sortie (66A ; 66B) des premier et second modules de puissance (60A ; 60B) et s'étendant indépendamment l'un de l'autre sont formés dans la carte d'entrée et de sortie (70), et **en ce que**
une borne (120) est montée sur le connecteur de sortie (100), la borne (120) comprenant :
une partie de borne de sortie (121a) destinée à être connectée au moteur électrique (12) ; et
des première et seconde parties de connexion de carte (121ca ; 121cb) s'étendant à partir de la partie de borne de sortie (121a), devant être connectées respectivement aux premier et second tracés conducteurs (76A ; 76B).

2. Unité de commande électronique (50) selon la revendication 1, dans laquelle les premier et second tracés conducteurs (76A ; 76B) sont agencés de manière à être axialement symétriques lorsque les premier et second tracés conducteurs (76A ; 76B) sont observés depuis un plan de la carte d'entrée et de sortie (70).

3. Unité de commande électronique (50) selon la revendication 1 ou 2,
dans laquelle une première borne de sortie (66A) du premier module de puissance comprend une première borne de sortie de phase A, une première borne de sortie de phase B et une première borne de sortie de phase C correspondant respectivement à une phase A, une phase B et une phase C du moteur électrique (12) ;
dans laquelle une seconde borne de sortie (66B) du second module de puissance comprend une seconde borne de sortie de phase A, une seconde borne de sortie de phase B et une seconde borne de sortie de phase C correspondant respectivement à la phase A, la phase B et la phase C du moteur électrique (12) ;
dans laquelle le premier tracé conducteur (76A) comprend un premier tracé conducteur de phase A connecté à et s'étendant à partir de la première borne de sortie de phase A du premier module de puissance (60A), un premier tracé conducteur de phase B connecté à et s'étendant à partir de la première borne de sortie de phase B (66A) du premier module de puissance, et un premier tracé conducteur de phase C connecté à et s'étendant à partir de la première borne de sortie de phase C du premier module de puissance (60A) ; et
dans laquelle le second tracé conducteur (76B) comprend un second tracé conducteur de phase A connecté à et s'étendant à partir de la seconde borne de sortie de phase A du second module de puissance (60B), un second tracé conducteur de phase B connecté à et s'étendant à partir de la seconde borne de sortie de phase B du second module de puissance (60B), et un second tracé conducteur de phase C connecté à et s'étendant à partir de la seconde borne de sortie de phase C du second module de puissance (60B).

4. Unité de commande électronique (50) selon la revendication 3,
dans laquelle la borne comprend une borne de phase A (121), une borne de phase B (122) et une borne de phase C (123) correspondant respectivement à la phase A, la phase B et la phase C du moteur électrique (12) ;
dans laquelle la borne de phase A (121) comprend la partie de borne de sortie (121a), la première partie de connexion de carte à connecter au premier tracé conducteur de phase A, et la seconde partie de connexion de carte à connecter au second tracé conducteur de phase A ;
dans laquelle la borne de phase B (122) comprend la partie de borne de sortie, la première partie de connexion de carte à connecter au premier tracé conducteur de phase B, et la seconde partie de connexion de carte à connecter au second tracé conducteur de phase B ; et
dans laquelle la borne de phase C (123) comprend la partie de borne de sortie, la première partie de connexion de carte à connecter au premier tracé conducteur de phase C, et la seconde partie de connexion de carte à connecter au second tracé conducteur de phase C.

5. Unité de commande électronique (50) selon la revendication 4, dans laquelle la borne de phase A, la borne de phase B et la borne de phase C sont moulées par insertion de manière à être mutuellement isolées, et se chevauchent mutuellement, lorsqu'un boîtier (90 ; 100) est formé.
